# EUROPÄISCHE PATENTSCHRIFT

(11) **EP 0 596 264 B1**
(45) Veröffentlichungstag und Bekanntmachung des Hinweises auf die Patenterteilung: **29.04.1998**
(21) Anmeldenummer: 93116042.8
(22) Anmeldetag: 05.10.1993
(51) Int. Cl.: H01L 29/861, H01L 27/06

(54) **Halbleiterbauelement mit hoher Durchbruchsspannung**
Semi-conductor device with high breakdown voltage
Dispositif semi-conducteur à haute tension de claquage

(30) Priorität: 07.10.1992 DE 4233773
(43) Veröffentlichungstag der Anmeldung: 11.05.1994
(73) Patentinhaber: Daimler-Benz Aktiengesellschaft, 70546 Stuttgart (DE)
(72) Erfinder: Neubrand,Horst,Dr.rer.nat., D-60598 Frankfurt (DE); Wondrak,Wolfgang,Dr.phil.nat., D-60385 Frankfurt (DE)
(74) Vertreter: Fröhling, Werner Otto, Dr.

(56) Entgegenhaltungen:
- EP-A- 0 191 476
- EP-A- 0 364 393
- DE-A- 3 806 164
- US-A- 3 990 102
- US-A- 4 984 052
- US-A- 5 151 768
- PROCEEDINGS OF THE 3RD INTERNATIONAL SYMPOSIUM ON POWER SEMICONDUCTOR DEVICES AND ICS April 1991 , BALTIMORE, MARYLAND, USA Seiten 16 - 21 A. NAKAGAWA 'Impact of Dielectric Isolation Technologiy on Power ICs'
- JAPANESE JOURNAL OF APPLIED PHYSICS, SUPPLEMENTS - EXTENDED ABSTRACTS OF THE 1991 INTERNATIONAL CONFERENCE ON SOLID STATE DEVICES AND MATERIALS, YOKOHAMA August 1991 , TOKYO JA Seiten 731 - 732 XP279525 AKIO NAKAGAWA ET TOMOKO MATSUDAI 'A Novel High Voltage Device Structure on Thin SOI for VLSIs'
- PATENT ABSTRACTS OF JAPAN vol. 10, no. 79 (E-391)28. März 1986 & JP-A-60 225 469 (TOSHIBA KK) 9. November 1985
- PATENT ABSTRACTS OF JAPAN vol. 14, no. 182 (E-916)12. April 1990 & JP-A-02 033 966 (FUJITSU LTD) 5. Februar 1990

## Beschreibung

Die Erfindung bezieht sich auf eine Halbleiterstruktur mit wenigstens einem lateralen, eine hohe Durchbruchspannung aufweisenden Halbleiterbauelement in einem Halbleiter aus einem Substrat, einer an das Substrat angrenzenden dielektrischen Schicht, einer auf der dielektrischen Schicht angeordneten niedrig dotierte Halbleiterschicht und mit stark dotierten Halbleiterzonen des Halbleiterbauelements, die in die niedrig dotierte Halbleiterschicht von der Oberfläche des Halbleiters her hineinragen.

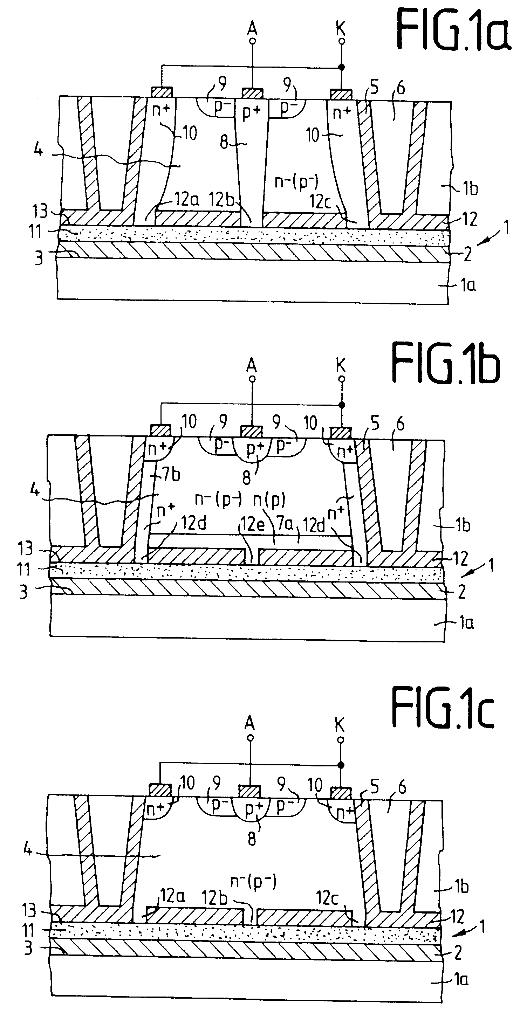

Eine derartige Halbleiterstruktur ist aus dem Aufsatz "Extension of the Resurf Principle to Dielectrically Isolated Power Devices" des Konferenzberichtes Conf. Report. ISPSD 1991, Baltimore, Seiten 27 - 30, bekannt (Fig. 1). Hierbei handelt es sich um die typische Struktur einer lateralen Diode auf einem dielektrisch isolierten Substrat. Derartige Strukturen, die dem allgemeinen Begriff "smart power technology" zuzuordnen sind, stellen ein Bindeglied zwischen digitalen Steuerungen und Leistungsbauelementen dar. Diese Technologie ermöglicht die Integration von Logik-, Schutz- und Diagnosefunktionen in Leistungsbauelementen.

Ein wesentlicher Gesichtspunkt der angesprochenen Technologie besteht darin, auf einem sogenannten Halbleiterwafer, der im folgenden nur als Halbleiter bezeichnet werden soll, mehrere Leistungsbauelemente zu integrieren, wobei die einzelnen Bauelemente gegeneinander vollständig isoliert sind.

Die gemeinsame Anordnung von logischen Schaltungen und Leistungsbauelementen in einem Chip ist in dem Aufsatz "Impact of Dielectric Isolation Technology on Power ICs" des Konferenzberichtes Conf. Report ISPSD 1991, Baltimore, Seiten 16 - 21 beschrieben.

Die bei mehreren Bauelementen erforderliche Isolation ist so durchzuführen, daß das jeweilige Bauelement nach allen Seiten hin gegenüber den übrigen angrenzenden Halbleiterbereichen elektrisch isoliert ist. Die seitliche Isolation erfolgt in der Regel in der Weise, daß Gräben um das Bauelement geätzt werden, die anschließend mit einem Dielektrikum ausgefüllt werden. Die dielektrische Isolation parallel zur Oberfläche des Halbleiters, also in vertikaler Richtung, erfolgt entweder durch die Bildung eines in Sperrichtung belasteten pn-Übergangs oder durch Verendung eines Dielektrikums, wie z. B. Siliziumoxid. Die Tendenz geht eindeutig zur dielektrischen Isolation hin, da bei dieser Technologie parasitäre Elemente vermieden werden und u. a. auch ein einfacheres Design bei erhöhter Störsicherheit möglich ist. Die erreichten maximalen Sperrspannungen bzw. Durchbruchsspannungen der Bauelemente werden einerseits durch die Isolationsfähigkeit des "vergrabenen Dielektrikums" bestimmt und zum anderen durch die Oberflächeneigenschaften in den Oberflächenbereichen, in denen die pn-Übergänge an die Oberfläche treten. Zur Vermeidung eines Oberflächendurchbruchs werden u. a. sogenannte Feldplatten im Bereich der pn-Übergänge an der Oberfläche eingesetzt.

Andererseits wird der Spannungsdurchbruch hauptsächlich dadurch begrenzt, daß die gesamte Spannung zwischen dem in der Regel geerdeten Substrat und den auf hohem Potential liegenden, hochdotierten Bereichen der Halbleiterbauelemente aufgebaut wird, was zu hohen Feldstärken führt. Einerseits führt die Erhöhung der Dicke der Driftzone zur Erhöhung der Durchbruchsspannung zu erheblichen Schwierigkeiten, da mit zunehmender Dicke der Aufwand für die seitliche Isolation durch Trennätzen und anschließender Auffüllung mit Isolationsmaterial schwierig wird. Andererseits kann zur Erzielung hoher Durchbruchsspannungen die Dicke des vergrabenen Dielektrikums nicht beliebig groß gemacht werden, da sonst wegen der zu geringen Wärmeleitfähigkeit eine unzureichende Abführung der Verlustleistung in Kauf genommen werden muß, was allgemein zu thermischen Problemen für die erzielbaren Parameter und den Betrieb der Bauelemente führt.

Bei Verwendung von Siliziumoxidschichten haben sich Dicken der dielektrischen Schicht im Bereich 0,5 bis 4,5 µm als noch brauchbar erwiesen.

Zur Erzielung höherer Durchbruchsspannungen für laterale, dielektrisch isolierte Bauelemente in Halbleitern aus Silizium mit einer Dicke der Driftzone unter 30 µm wurden verschiedene Maßnahmen diskutiert, wie z. B. zusätzliche Diffusionsgebiete im Substrat, die mit den dielektrisch isolierten Bauelementen verbunden sein können. Diese Lösung hat jedoch den Nachteil, daß sie technisch nur schwer zu realisieren ist und andererseits wiederum die ansonsten gute dielektrische Isolation stark beeinträchtigt.

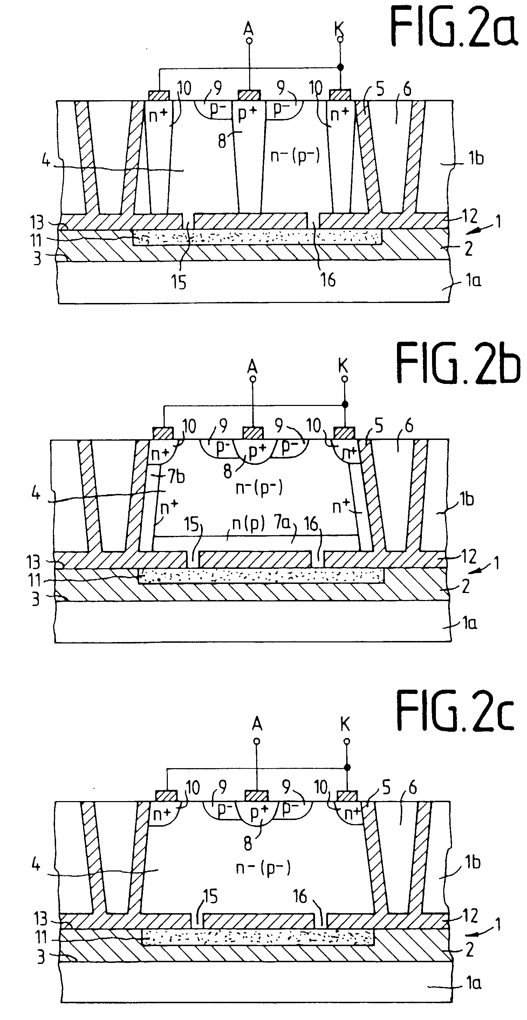

Eine andere bekannte Maßnahme zur Erreichung höherer Durchbruchsspannungen ist die Einbringung vergrabener Dotierungen an der Grenzfläche zu der dielektrischen Schicht, wie der Patentschrift DE 38 06 164 und der japanischen Offenlegungsschrift J2-16751 zu entnehmen ist. Diese Maßnahme ist in beiden Druckschriften in Fig. 2 dargestellt. Damit erfolgt eine etwas günstigere Potentialverteilung in den Bauelementen; trotzdem ist die Erhöhung der Durchbruchsspannung relativ gering und außerdem abhängig von der Dicke der dielektrischen Schicht. Die maximal berichtete Durchbruchsspannung liegt bei 600 V für eine Siliziumschichtdicke von 20 µm. Dies reicht für verschiedene Anwendungsgebiete nicht aus.

Eine weitere Maßnahme zur Erreichung höherer Durchbruchsspannungen ist der Patentschrift EP-B-0 025 050 zu entnehmen, nämlich die dielektrische Schicht durch eine halblisolierende Schicht zu ersetzen, die Einfangzustände für Ladungsträger aufweist. Eine solche Schicht führt aber zwangsläufig auch zur Emmision von Ladungsträgern und beeinträchtigt dadurch insbesondere das statische Sperrverhalten und die dynamischen Eigenschaften der Bauelemente.
Vorteilhaft wäre eine Halbleiterstruktur, die bei gleicher oder geringerer Dicke der halbleitenden Schicht höhere Durchbruchsspannungen besitzt. Gleichzeitig ist es wünschenswert, die Dicke der dielektrischen Schicht zu reduzieren. Dabei sollen aber die übrigen Bauelementeigenschaften nicht beeinträchtigt werden.

Der Erfindung liegt das Problem zugrunde, eine Halbleiterstruktur mit wenigstens einem Halbleiterbauelement zu schaffen, bei dem eine ausreichend hohe Durchbruchsspannung auch mit einer dünnen Halbleiterschicht erzielbar ist und bei dem die laterale Isolation einfach realisierbar ist.

Dabei soll gleichzeitig die Abängigkeit von der Dicke der dielektrischen Schicht reduziert und die Einbringung von zusätzlichen Rekombinations-Generationszentren vermieden werden.

Das Problem wird bei einer Halbleiterstruktur der eingangs beschriebenen Art erfindungsgemäß dadurch gelöst, daß innerhalb der an das Substrat angrenzenden dielektrischen Schicht wenigstens unter demjenigen Bereich des lateralen Halbleiterbauelements, der im Sperrzustand des Halbleiterbauelements gegenüber dem Substrat ein hohes Potential aufweist, eine elektrisch leitfähige Schicht eingelagert ist, die sich im Sperrzustand gegenüber dem Substrat auf einem erhöhten Potential befindet. Dadurch wird die elektrische Feldstärke im sperrenden Bauelement reduziert. Die leitfähige Schicht ist insbesondere unkontaktiert (floatend) oder durch elektrische Kontakte dem lateralen Halbleiterbauelement oder zur Oberfläche der Halbleiterstruktur mit bestimmten Potentialen belegbar. Sie kann ebenso in lateraler Richtung unterbrochen sein. Durch die Anwesenheit dieser elektrisch leitfähigen Schicht wird ein Teil des Spannungsabfalls in die dielektrische Schicht hinein verschoben, wodurch eine höhere Durchbruchsspannung der Bauelemente erreicht wird.

Als weitere Halbleiterzonen sind von der Oberfläche her insbesondere eine erste Halbleiterzone, die einen ersten Leitfähigkeitstyps mit einer höheren Fremdatomkonzentration als die niedrig dotierte Halbleiterzone aufweist, eine zweite Halbleiterzone, die eine niedrigere Fremdatomkonzentration als die erste Halbleiterzone bei gleichem Leitfähigkeitstyp aufweist und die erste Halbleiterzone umgibt, und eine dritte Halbleiterzone in die niedrig dotierte Halbleiterzone eingelassen, die bei einem zweiten Leitfähigkeitstyp eine Fremdatomkonzentration aufweist, die höher ist als diejenige der niedrig dotierten Halbleiterzone und die außerhalb der zweiten Halbleiterzone liegt. Eine derartige Anordnung bildet eine laterale Diode. Der Bereich der niedrig dotierten Halbleiterzone zwischen der ersten und der dritten Halbleiterzone wird im folgenden Driftzone genannt. Zweckmäßigerweise erstreckt sich die leitfähige Schicht unterhalb wenigstens zwischen der ersten und dritten Halbleiterzone und ist mit diesen kontaktiert.

Bei einer anderen zweckmäßigen Ausführungsform erstreckt sich die leitfähige Schicht unterhalb wenigstens zwischen der ersten und dritten Halbleiterzone und ist unterhalb der ersten und dritten Halbleiterzone wenigstens einmal zwischen diesen Halbleiterzonen mit der Driftzone kontaktiert. Die Kontaktierung kann auch mit vierten Halbleiterzonen erfolgen, die eine niedrigere Fremdatomkonzentration haben als die erste oder dritte Halbleiterzone und auf einem an die dielektrische Schicht angrenzenden Bodenabschnitt der Driftzone sowie neben seitlichen dielektrischen Schichten ausgebildet ist. Eine hohe Durchbruchsspannung ergibt sich auch bei einer Anordnung der leitfähigen Schicht unterhalb der ersten und dritten Halbleiterzone und Kontaktierung der leitfähigen Schicht mit der Driftzone an Stellen zwischen der ersten und dritten Halbleiterzone. Die Halbleiterstruktur kann dabei so ausgebildet sein, daß die ersten und dritten Halbleiterzonen bis zur dielektrischen Schicht verlaufen oder Abstände zu dieser aufweisen. Auch die Kontaktierung an den gleichen Stellen mit vierten Halbleiterzonen, die eine niedrigere Fremdatomkonzentration hat als die erste oder dritte Halbleiterzone und auf einem an die dielektrische Schicht angrenzenden Bodenabschnitt der Driftzone sowie neben seitlichen dielektrischen Schichten die niedrig dotierte Zone umgeben, ist möglich. Die Erhöhung der Durchbruchsspannung wird auch mit einer leitfähigen Schicht erreicht, die lateral über die erste und dritte Halbleiterschicht hinausgeführt und mit einer Elektrode kontaktiert ist, an die ein von außen vorgebbares Potential anlegbar ist. Die Verbesserung hinsichtlich der Durchbruchsspannung läßt sich bei dieser Anordnung unabhängig davon erreichen, ob die erste und dritte Halbleiterzone bis an die dielektrische Schicht heranreichen oder nicht oder ob die vierten Halbleiterzonen, die das laterale Halbleiterbauelement umgeben, vorhanden sind.

Eine Erhöhung der Durchbruchsspannung tritt aber auch ein, wenn die leitfähige Schicht nicht von außen kontaktiert ist und die vorstehend erwähnte Ausbildung der Halbleiterstruktur vorhanden ist.
Eine weitere Möglichkeit zur Erhöhung der Durchbruchspannung besteht darin, eine leitfähige Schicht aus einzelnen, voneinander getrennten Teilbereichen aufzubauen.

Die Erfindung wird im folgenden anhand von in einer Zeichnung dargestellten Ausführungsbeispielen näher beschrieben, aus denen sich weitere Einzelheiten, Merkmale und Vorteile ergeben.

Es zeigen:
- Fig. 1a: eine Halbleiterstruktur mit einer ersten Ausführungsform einer Diode und mit einer unter den Anoden- und Kathodenbereichen mit einer halbleitenden Schicht verbundenen elektrisch leitfähigen Schicht im Querschnitt;
- Fig. 1b: eine Halbleiterstruktur mit einer zweiten Ausführungsform einer Diode und mit einer unter den Anoden- und Kathodenbereichen mit einer halbleitenden Schicht verbundenen elektrisch leitfähigen Schicht im Querschnitt;
- Fig. 1c: eine Halbleiterstruktur mit einer dritten Ausführungsform einer Diode und mit einer unter den Anoden- und Kathodenbereichen mit einer halbleitenden Schicht verbundenen elektrisch leitfähigen Schicht im Querschnitt;
- Fig. 2a: eine Halbleiterstruktur mit einer ersten Ausführungsform einer Diode und mit einer zwischen den Anoden- und Kathodenbereichen mit einer halbleitenden Schicht verbundenen elektrisch leitfähigen Schicht im Querschnitt;
- Fig. 2b: eine Halbleiterstruktur mit einer zweiten Ausführungsform einer Diode und mit einer zwischen den Anoden- und Kathodenbereichen mit einer halbleitenden Schicht verbundenen elektrisch leitfähigen Schicht im Querschnitt;
- Fig. 2c: eine Halbleiterstruktur mit einer dritten Ausführungsform einer Diode und mit einer zwischen den Anoden- und Kathodenbereichen mit einer halbleitenden Schicht verbundene elektrisch leitfähigen Schicht im Querschnitt;
- Fig. 3a: eine Halbleiterstruktur mit einer ersten Ausführungsform einer Diode und mit einer außerhalb des Bereichs der Diode mit einer halbleitenden Schicht verbundenen elektrisch leitfähigen Schicht im Querschnitt;
- Fig. 3b: eine Halbleiterstruktur mit einer zweiten Ausführungsform einer Diode und mit einer außerhalb des Bereichs der Diode mit einer halbleitenden Schicht verbundenen elektrisch leitfähigen Schicht im Querschnitt;
- Fig. 3c: eine Halbleiterstruktur mit einer dritten Ausführungsform einer Diode und mit einer außerhalb des Bereichs der Diode mit einer halbleitenden Schicht verbundenen elektrisch leitfähigen Schicht im Querschnitt;
- Fig. 4a: eine Halbleiterstruktur mit einer ersten Ausführungsform einer Diode und mit einer nicht kontaktierten, elektrisch leitfähigen Schicht im Querschnitt;
- Fig. 4b: eine Halbleiterstruktur mit einer zweiten Ausführungsform einer Diode und mit einer nicht kontaktierten leitfähigen Schicht im Querschnitt;
- Fig. 4c: eine Halbleiterstruktur mit einer dritten Ausführungsform einer Diode und mit einer nicht kontaktierten leitfähigen Schicht im Querschnitt;
- Fig. 5a: eine Halbleiterstruktur mit einer ersten Ausführungsform einer Diode und einer in einzelne, voneinander getrennte Teilbereiche ausgebildeten, elektrisch leitfähigen Schicht im Querschnitt;
- Fig. 5b: eine Halbleiterstruktur mit einer zweiten Ausführungsform einer Diode und einer in einzelne, voneinander getrennte Teilbereiche aufgeteilten elektrisch leitenden Schicht im Querschnitt;
- Fig. 5c: eine Halbleiterstruktur mit einer dritten Ausführungsform einer Diode und einer in einzelne, voneinander getrennte Teilbereiche aufgeteilten elektrisch leitenden Schicht im Querschnitt;
- Fig. 6: eine herkömmliche Halbleiterstruktur mit einer Diode und einer lateralen Trennstruktur und
- Fig. 7: eine herkömmliche Halbleiterstruktur mit einer Diode höherer Durchbruchsspannung und einer lateralen Trennstruktur.

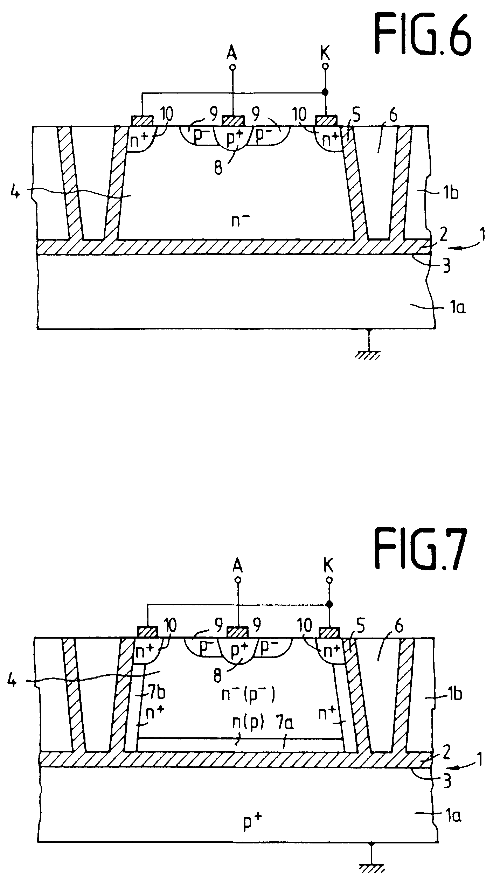

Die in Fig. 6 dargestellte, herkömmliche Anordnung besteht aus einer durch Verbindung eines Siliziumsubstrats 1a und eines n-Si-Substrats 1b nach Direktverbindungstechnik gebildeten Halbleiterstruktur 1 mit einem an der Verbindungsgrenzfläche 3 erzeugten Oxidfilm 2, im folgenden auch dielektrische Schicht 2 genannt. Zur lateralen Isolation ist ein Teil des n-Substrats 1b als Graben mindestens bis zum Oxidfilm 2 geätzt, so daß eine inselförmige n-Schicht 4 gebildet wird. Der Graben ist durch einen Oxidfilm 5 und durch eine Schicht aus polykristallinem Silizium 6 gefüllt. In der n-Schicht 4 ist eine p⁺-Schicht 8, umgeben von einer p-Schicht 9 angeordnet, so daß eine Diode gebildet wird.

In einem Flächenteil der n-Schicht wird eine n⁺-Schicht 10 zur besseren Kontaktierbarkeit erzeugt.

Da das Potential am Substrat 1 a normalerweise auf OV gesetzt ist und da der dünne Oxidfilm eine relativ hohe Dielektrizitätskonstante hat, liegt der größte Teil der an die Diode angelegten Sperrspannung in der Verarmungsschicht unterhalb der n⁺-Schicht 10. Die hierdurch entstehende ungünstige Verteilung des elektrischen Feldes ist z. B.im Aufsatz "Impact of Dielectric Isolation Technology on Power ICs" des Konferenzbandes Conf. Report ISPSD 1991, Baltimore, Seiten 16 - 21, beschrieben.

Die in Fig. 7 dargestellte Diodenanordnung ist ähnlich aufgebaut wie die in Fig. 6 gezeigte Diodenanordnung, nur sind hier zusätzlich eine n-dotierte Zone 7a auf dem Bodenabschnitt der Si-Schicht 4 und eine hochdotierte Zonen 7b am Umfang der Schicht 4 ausgebildet. Bei geeigneter Dotierung dieser Schichten wird bei Anlegen einer Sperrvorspannung der Diode die Schicht 7a auf dem Bodenabschnitt verarmt, wobei in seitlicher Richtung eine Potentialdifferenz erzeugt wird, die die Spannung zwischen den Elektroden A und K aufteilt, wodurch ein Teil der angelegten Spannung durch den Oxidfilm 2 aufgenommen wird. Die erzeugte Potentialdifferenz in seitlicher Richtung ist aber dadurch begrenzt, daß mit Erhöhung der Dotierungskonzentration der der Schicht 7a bald keine vollständige Verarmung mehr auftritt und das elektrische Feld unterhalb der Zone 8 rasch ansteigt, siehe Offenlegungsschrift J2-16751. Zudem macht die technische Realisierung dieser Lösung Probleme, da die Zone 7a vor der Herstellung der Bauelementstruktur (Zonen 5, 6, 7b, 8, 9 und 10) hergestellt werden muß, und deshalb die zulässigen Prozeßtemperaturen eingeschränkt werden müssen. Ansonsten diffundiert die Zone 7a auf eine unzulässige Tiefe aus.

In den folgenden Ausführungsbeispielen der Erfindung wird der Einfachheit halber jeweils eine Diodenstruktur beschrieben.

Die Erfindung kann aber auch für alle anderen unipolaren und bipolaren Bauelemente eingesetzt werden. Beispielsweise können die Dotierungen n und p der Beispiele vertauscht werden. Die Bauelemente müssen nicht symmetrisch ausgelegt sein, die laterale Isolation durch die Trenngräben kann auch weiter von den Bauelementen entfernt sein.

Des weiteren sind bei allen Bauelementen auch die bekannten Maßnahmen zur Reduzierung von Oberflächenfeldstärken, wie z. B. Widerstandsfeldplatten und Feldplatten, aber auch die Weglassung von niederdotierten Zonen 9 (JTE) denkbar. Als Dielektrika sind auch andere Stoffe als SiO₂ einsetzbar, die thermisch oder per Abscheideverfahren auf die Oberflächen aufgebracht werden wie beispielsweise Si₃N₄ Al₂O₃, AlN etc.

Die in Fig. 1a dargestellte Anordnung besteht aus einer durch die Verbindung eines Silizium-Substrats 1a und eines n-dotierten Substrats 1b nach der Direktverbindungstechnik gebildeten Halbleiterstruktur 1 mit einer an der Verbindungsfläche 3 des Si-Substrats 1a erzeugten Schichtenfolge eines Oxidfilms 2, einer elektrisch leitenden Schicht 11, insbesondere aus polykristallinem Silizium, und eines zweiten Oxidfilms 12, im folgenden auch dielektrische Schicht 12 genannt. Zur lateralen Isolation ist ein Teil des n-Substrats 1b als Graben bis zum Oxidfilm 12 (bzw. 2) geätzt, so daß eine inselförmige n-Schicht 4 gebildet wird. Der Graben ist durch einen Oxidfilm 5 und durch eine Schicht aus polykristallinem Silizium 6 gefüllt.

In der n-Schicht 4 ist eine erste Halbleiterzone eines ersten Leitfähigkeitstyps, die eine höhere Fremdatomkonzentration als die Driftzone aufweist, vorgesehen und von einer zweiten Halbleiterzone umgeben, die bei gleichem Leitfähigkeitstyp eine niedrigere Fremdatomkonzentration hat als die erste. Die erste Halbleiterzone ist eine p⁺-Schicht 8, die so von der zweiten Halbleiterzone, einer p⁻-Schicht, umgeben ist, daß eine Diode gebildet wird. In einem Flächenanteil der n-Schicht 4 ist als dritte Halbleiterschicht eine n⁺-Schicht 10 zur besseren Kontaktierung der Kathode K gebildet. Die p⁺-Schicht 8 und die n⁺-Schicht 10 erstrekken sich bis zur elektrisch leitenden Schicht 11, wobei durch Ausnehmungen 12a, b, c im zweiten Oxidfilm 12 unterhalb der als Anoden- und Kathodenzonen ausgebildeten Schichten 8, 10 eine leitende Verbindung zwischen den Schichten 8, 10 und 11 besteht. Die n⁺-Schicht 10 ist als Kathode K kontaktiert. Die p⁺-Schicht 8 ist als Anode A kontaktiert.
Beim Anlegen einer Sperrspannung an die Diode fließt ein Strom zwischen den Schichten 8 und 10 durch die leitfähige Schicht 11, so daß in seitlicher Richtung die volle Potentialdifferenz erzeugt wird, und daraus eine fast vollständige Reduzierung des vertikalen elektrischen Felds resultiert.

Die in Fig. 1b dargestellte Anordnung unterscheidet sich von der Anordnung gem. Fig. 1a einerseits darin, daß die p⁺-Schicht 8 und die n⁺-Schichten 10 nicht bis zum Boden der Driftzone verlaufen und andererseits Halbleiterzonen auf dem Boden der Driftzone und an den Seitenwänden der Gräben eingebracht sind. Die vierten Halbleiterzonen haben eine niedrigere Fremdatomkonzentration als die erste oder dritte Halbleiterzone aber eine höhere Dotierung als die Driftzone. Es handelt sich bei den vierten Halbleiterzonen um eine mit 7a und eine mit 7b bezeichnete n-Zone und n⁺-Zone. Die Zone 7b ist durch Ausnehmungen 12d in dem Oxidfilm 12 mit der leitenden Schicht 11 verbunden. Ebenso ist die Zone 7a an einer Stelle unterhalb der Anode K durch eine Ausnehmung 12e in dem Oxidfilm 12 mit der leitenden Schicht 11 verbunden. Bei dieser Ausführungsform nimmt die leitfähige Schicht nicht die gesamte Sperrspannung auf, sondern nur einen um den in der Schicht 4 vertikal unter der Schicht 8 abfallenden Spannungswert reduzierten Wert. In diesem Fall wird die Dotierung der n-Schicht 4 so gering gewählt, daß beim vollständigen Verarmen der Schicht 4 bis zu der Zone 7a die kritische Feldstärke nicht überschritten wird.

Die in Fig. 1c dargestellte Anordnung hat bis auf die Zonen 7a, 7b den gleichen Aufbau wie die in Fig. 1b gezeigte Anordnung. Gleiche Elemente sind wie auch in den folgenden Figuren mit gleichen Bezugsziffern versehen. Die Tiefen der Schichten 8 und 10 sind geringer als die Dicke der Schicht 4. Bei dieser Ausführungsform nimmt die leitfähige Schicht 11 nur eine Spannung auf, die der angelegten Sperrspannung minus der Summe der in der Schicht 4 unter der Schicht 8 und der unter der Schicht 10 abfallenden Spannungen entspricht. Der damit erreichbare Wert der Durchbruchsspannung ist dabei aber immer noch höher als bei den bereits bekannten Anordnungen nach Fig. 6 oder Fig. 7.

Die in Fig. 2a dargestellte Anordnung besteht aus einer durch die Verbindung eines Si-Substrats 1a und eines n-Si-Substrats 1b nach Direktverbindungstechnik gebildeten Halbleiterstruktur 1 mit einer an der Verbindungsgrenzfläche 3 erzeugten Schichtenfolge eines Oxidfilms 2, einer elektrisch leitenden Schicht 11, insbesonders aus polykristallinem Silizium, und eines zweiten Oxidfilms 12.

Zur lateralen Isolation ist ein Teil des n-Substrats 1b als Graben bis zum Oxidfilm 12 (bzw. 2) geätzt, so daß eine inselförmige n-Schicht 4 gebildet wird. Der Graben ist durch einen Oxidfilm 5 und durch eine Schicht aus polykristallinem Silizium 6 gefüllt. In der n-Schicht 4 ist eine p⁺-Schicht 8, umgeben von einer p-Schicht 9 angeordnet, so daß eine Diode gebildet wird. In einem Flächenteil der n-Schicht 4 wird eine n⁺-Schicht 10 zur besseren Kontaktierung der Kathode K gebildet. Die p⁺-Schicht 8 und die n⁺-Schicht 10 erstrecken sich in der Tiefe über die gesamte Stärke der n-Schicht 4 und sind jeweils als Kathode K bzw. Anode A kontaktiert.

Die elektrisch leitende Schicht 11 ist durch Ausnehmungen 15, 16 im zweiten Oxidfilm 12 unterhalb der Anoden- und Kathodenzonen und mit den Schichten 8 und 10 an der Grenzfläche 13 verbunden.

Beim Anlegen einer Sperrspannung an die Diode breitet sich eine Raumladungszone vom p⁺-Bereich 8 in die n-Schicht 4 aus. Die gesamte elektrisch leitende Schicht 11 nimmt dan das Potential an der Verbindungsstelle an, das durch die Raumladungszone festgelegt ist. Dieses Potential wird durch eine Spannung am Oxidfilm 2 aufgenommen. Auf diesen Betrag steigt der Spannungsabfall in der eine Silizium-Insel bildenden der Schicht 4 und an der Oxidschicht 12 im Bereich der Anode mit der Schicht 8 an, während der Spannungsabfall im Bereich der Kathode mit der Schicht 10 um diesen Betrag reduziert wird. Bei geeigneter Wahl der Lage der Verbindungsstelle und der Dotierung des n-Substrats 1b nimmt die elektrisch leitende Schicht 11 etwa den halben Wert der maximalen Sperrspannung an, so daß das vertikale elektrische Feld im Halbleiter etwa auf die Hälfte reduziert werden kann.

Die in Fig. 2b gezeigte Anordnung weist bis auf die folgende beschriebene Variation den gleichen Aufbau wie die Anordnung gem. Fig. 2a auf. Es sind bei der Anordnung gem. Fig. 2b Zonen 7a, 7b mit erhöhter Dotierung auf dem Boden der Silizium-Schicht 4 und an den Seitenwänden der Gräben eingebracht, während die Tiefen der Schichten 8 und 10 geringer sind als die Dicke der Si-Schicht 4. Bei dieser Ausführungsform wird die Dotierung der n-Schicht 4 und der n-Schicht 7a so gering gewählt, daß beim vollständigen Verarmen der Schichten 4 und 7a bis zur Verbindungsstelle mit der elektrisch leitfähigen Schicht 11 die kritische Feldstärke nicht überschritten wird.

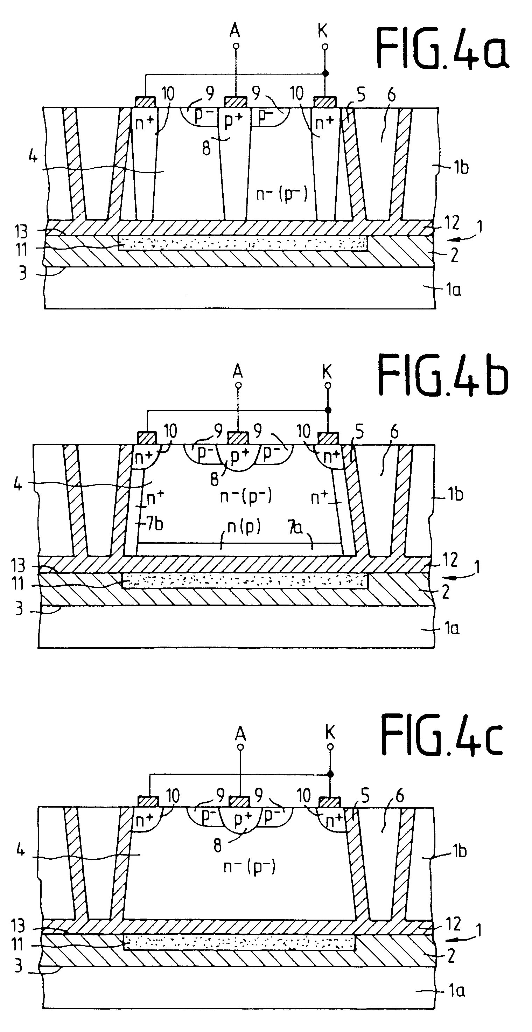

Die in Fig. 2c gezeigte Anordnung unterscheidet sich von der Anordnung gem. Fig. 2b darin, daß keine Zonen 7a, 7b vorhanden sind. Stattdessen füllt die n-Schicht 4 den gem. Fig. 2b von den Zonen 7a, 7b eingenommenen Raum aus. Die Oxidschicht 13 weist die gleichen Ausnehmungen 15, 16 wie gem. Fig. 4b auf uns stellt eine leitende Verbindung zwischen der n⁻-Schicht 4 und der leitenden Schicht 11 her, die ebenso wie bei den Ausführungsformen gem. Fig. 2a und 2b sich im wesentlichen über den Bereich unterhalb der n⁻-Schicht 4 erstreckt. Bei dieser Ausführungsform wird die Dotierung der n-Schicht 4 so gering gewählt, daß beim vollständigen Verarmen der n-Schicht 4 die kritische Feldstärke nicht überschritten wird. Der damit erreichbare Wert der Durchbruchsspannung beträgt fast doppelt so viel wie bei den bereits bekannten Anordnungen nach Fig. 6 oder Fig. 7.

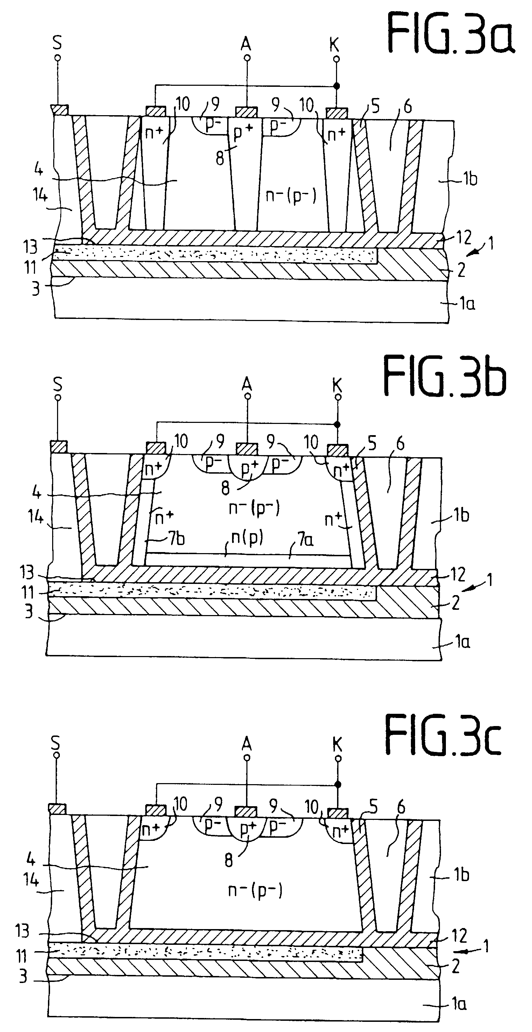

Die in Fig. 3a dargestellte Anordnung hat im wesentlichen den gleichen Aufbau wie die in Fig. 2a gezeigte Anordnung. Sie besteht aus einer durch die Verbindung eines Si-Substrats 1a und eines n-Si-Substrats 1b nach Direktverbindungstechnik gebildeten Halbleiterstruktur 1 mit einer an der Verbindungsgrenzfläche 3 erzeugten Schichtenfolge eines Oxidfilms 2, einer elektrisch leitenden Schicht 11, insbesondere aus polykristallinem Silizium, und eines zweiten Oxidfilms 12. Zur lateralen Isolation ist ein Teil des n-Substrates 1b als Graben bis zum Oxidfilm 12 (bzw. 2) geätzt, so daß eine inselförmige n-Schicht 4 gebildet wird. Der Graben ist durch einen Oxidfilm 5 und durch eine Schicht aus polykristallinem Silizium 6 gefüllt. In der n-Schicht 4 ist eine p⁺-Schicht 8, umgeben von einer p-Schicht 9 angeordnet, so daß eine Diode gebildet wird. In einem Flächenteil der n-Schicht 4 wird eine n⁺-Schicht 10 zur besseren Kontaktierung der Kathode gebildet.

Außerhalb des durch die Isolation eingeschlossenen Bereichs der Schicht 4 und der Schichten 8, 9, 10, ist die elektrisch leitfähige Schicht 11, die den Bereich unterhalb der Schichten 4, 8, 9, 10 abdeckt, über eine Silizium-Schicht 14 mit der Oberfläche der Halbleiter-Struktur 1 verbunden und kann über einen Kontakt S auf ein von außen vorgebbares Potential gelegt werden. Auf diese Weise kann für jeden Betriebszustand der Diode die Feldverteilung von außen beeinflußt und optimiert werden.

Zum Beispiel kann über einen Spannungsteiler das Potential am Kontakt S auf die Hälfte der Spannung zwischen Anode A und Kathode K festgelegt werden, was unabhängig vom Potential des Bauelements oder des Substrats eine sehr günstige Feldverteilung bewirkt.

Die in Fig. 3b dargestellte Anordnung entspricht bis auf die Kontaktierung der leitfähigen Schicht 11 der Anordnung gem. Fig. 2b. Die äußere Kontaktierung der Schicht 11 entspricht derjenigen des in Fig. 3a dargestellten Ausführungsbeispiels. Die Schichten 11 und 7a, 7b sind nicht miteinander verbunden.

Es sind Zonen erhöhter Dotierung 7a, 7b auf dem Bode der n-Schicht 4 und auf den Seitenwänden der Gräben eingebracht, während die Tiefen der Zonen 8 und 10 geringer sind als die Dicke der n-Schicht 4. Bei dieser Ausführungsform muß die Spannung zwischen Anode A und Kontakt S vertikal unter der Schicht 8 bis zur Grenzfläche 13 aufgenommen werden, während sich der Spannungsabfall unter der Kathode K um diesen Betrag reduziert. Die Dotierung der Schichten 4 ist so gewählt, daß beim vollständigen Verarmen der Schicht 4 bis zu der Zone 7a die kritische Feldstärke nicht überschritten wird.

Die Anordnung gem. Fig. 3c entspricht bis auf die Kontaktierung der leitfähigen Schicht 11 der Anordnung gem. Fig. 2c. Die äußere Kontaktierung der Schicht 11 entspricht derjenigen der in Fig. 3a und 3b dargestellten Ausführungsbeispiele. Die Schichten sind nicht miteinander verbunden. Die Tiefen der Zonen 8 und 10 sind geringer als die Dicke der n-Schicht 4. Die Dotierung der n-Schicht 4 ist so gewählt, daß beim vollständigen Verarmen der n-Schicht 4 die kritische Feldstärke nicht überschritten wird. Der erreichbare Wert der Durchbruchsspannung beträgt etwa doppelt so viel wie bei den bekannten Anordnungen nach Fig. 6 oder Fig. 7.

Die in Fig. 4a gezeigte Anordnung besteht aus einer durch die Verbindung eines Silizium-Halbleitersubstrats 1a und eines n-Si-Substrats 1b nach Direktverbindungstechnik gebildeten Halbleiterstruktur 1 mit einer an der Verbindungsgrenzfläche 3 erzeugten Schichtenfolge eines Oxidfilms 2, einer elektrisch leitenden Schicht 11, z. B. aus polykristallinem Silizium, und eines zweiten Oxidfilms 12.

Zur lateralen Isolation ist ein Teil des n-Substrats 1b als Graben bis zum Oxidfilm 12 (bzw. 2) geätzt, so daß eine inselförmige n-Schicht 4 gebildet wird. Der Graben ist durc einen Oxidfilm 5 und durch eine Schicht aus polykristallinem Silizium 6 gefüllt. In der n-Schicht 4 ist eine p⁺-Schicht 8, umgeben von einer p-Schicht 9 angeordnet, so daß eine Diode gebildet wird. In einem Flächenteil der n-Schicht 4 wird eine n⁺-Schicht 10 zur besseren Kontaktierung der Kathode K gebildet.

Insofern entspricht die Anordnung bis auf die Kontaktierung der Schicht 11 gem. Fig. 4a derjenigen von Fig. 3a.

Die elektrisch leitfähige Schicht 11 ist nicht kontaktiert. Beim Betrieb des Bauelements stellt sie sich durch Influenzladungen auf ein mittleres Potential ein, das einerseits durch das Flächenladungsverhältnis der p-Schichten 8, 9 und der n-Schichten 4, 10 und andererseits durch das Verhältnis der Dicke der Oxidschichten 2 und 12 bestimmt wird. Die Wirkungsweise ist entsprechend der des Ausführungsbeispiels aus Fig. 3, wobei das von außen vorgegebene Potential durch das sich von allein einstellende mittlere Potential der elektrisch leitfähigen Schicht 11 ersetzt wird.

Die in Fig. 4b dargestellte Anordnung weist bis auf einen Unterschied den in Fig. 3b dargestellten Aufbau auf. Der Unterschied ist der gleiche wie zwischen den in Fig. 3a und 4a dargestellten Anordnungen und bezieht sich auf die elektrisch leitfähige Schicht 11. Es sind Zonen erhöhter Dotierung 7a, 7b auf dem Boden der n-Schicht 4 und an den Seitenwänden der Gräben eingebracht, während die Tiefen der Zonen 8 und 10 geringer sind als die Dicke der n-Schicht 4. Bei dieser Ausführungsform muß die Spannung zwischen Anode A und dem Potential der elektrisch leitfähigen Schicht 11 vertikal unter der p⁺-Schicht 8 bis zur Grenzfläche 13 aufgenommen werden, während sich der Spannungsabfall unter der Kathode K um diesen Betrag reduziert. Zum Erreichen der maximalen Sperrspannung sind die Dotierungen der Schichten 4 und 7a so gewählt, daß beim vollständigen Verarmen dieser Schichten 4 und 7a die kritische Feldstärke nicht überschritten wird.

Die Anordnung gem. Fig. 4c ist eine weitere Variation der Anordnung gem. Fig. 4a, wobei die Tiefen der Zonen 8 und 10 geringer sind als die Dicke der n-Schicht 4. Zwischen der in Fig. 4c dargestellten Anordnung und der Anordnung gem. Fig. 3c besteht ein Unterschied in der Größe der Schicht 11. Die Schicht 11 ist gem. Fig. 3c von außen kontaktiert, während die Schicht 11 gem. Fig. 4c isoliert ist und nur unterhalb der von der n⁻-Schicht 4 eingenommenen Insel verläuft.

Die Dotierung der n-Schicht 4 ist so gewählt, daß beim vollständigen Verarmen der n-Schicht 4 die kritische Feldstärke nicht überschritten wird. Der erreichbare Wert der Durchbruchsspannungen ist gegenüber den bekannten Anordnungen nach Fig. 6 oder Fig. 7 etwa um den Wert des Potentials der elektrisch leitfähigen Schicht 11 angehoben.

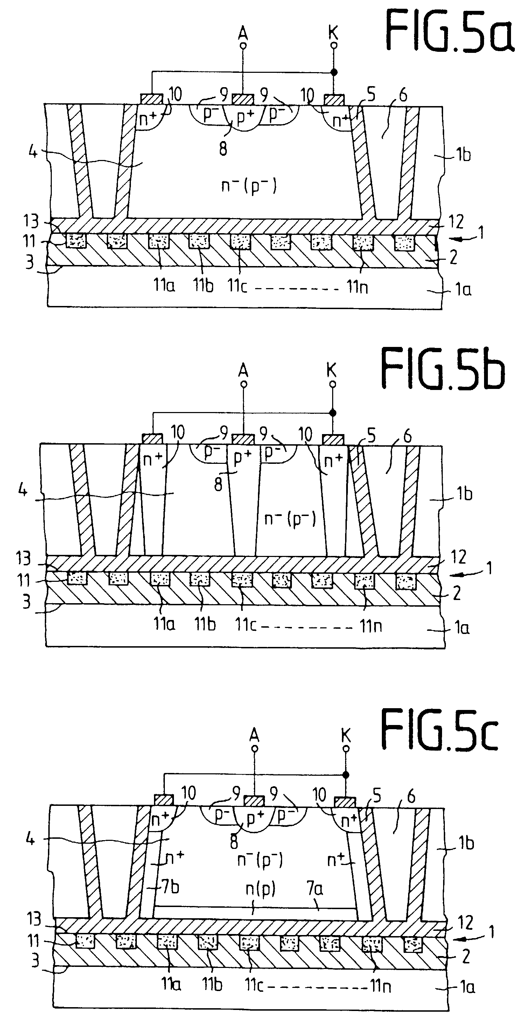

Die in Fig. 5a dargestellte Anordnung besteht aus einer durch die Verbindung eines Si-Substrats 1a und eines n-Si-Substrats 1b nach Direktverbindungstechnik gebildeten Struktur 1 mit einer an der Verbindungsgrenzfläche 3 erzeugten Schichtenfolge eines Oxidfilms 2, einer elektrisch leitenden Schicht 11, insbesondere aus polykristallinem Silizium, und eines zweiten Oxidfilms 12. Zur lateralen Isolation ist ein Teil des n-Substrats 1b als Graben bis zum Oxidfilm 12 (bwz. 2) geätzt, so daß eine inselförmige n-Schicht 4 gebildet wird. Der Graben ist durch einen Oxidfilm 5 und durch eine Schicht aus polykristallinem Silizium 6 gefüllt. In der n-Schicht 4 ist eine p⁺-Schicht 8, umgeben von einer p-Schicht 9 angeordnet, so daß die Diode gebildet wird. In einem Flächenteil der n-Schicht 4 wird eine n⁺-Schicht 10 zur besseren Kontaktierung der Kathode gebildet.

Die Schichten 8 und 10 weisen einen Anodenanschluß A und einen Kathodenanschluß K auf.
Die elektrisch leitfähige Schicht 11 ist in einzelne, voneinander isolierte Teilbereiche 11a, 11b, 11c ... 11n unterteilt. Beim Betrieb des Bauelements stellt sich jeder Teilbereich durch Influenzladungen auf ein mittleres Potential ein, das hauptsächlich durch das Verhältnis der Dicken der Oxidschichten 2 und 12 und das Potential des über dem Teilbereich liegenden Hallbeiterbereichs festgelegt ist. Dadurch kann der Spannungsabfall unter der Kathode K stark reduziert werden, ohne einen zusätzlichen Spannungsabfall unter der Anode A hervorzurufen.

Bei geeigneter Wahl der Oxiddicken der Schichten 2 und 12 kann ein Verlauf des elektrischen Felds erreicht werden, der dem gem. Fig. 1 sehr nahe kommt, wobei zur Erreichung dieses Feldverlaufs kein erhöhter Sperrstrom zwischen den Kontakten A und K hervorgerufen wird.

Die Anordnung gem. Fig. 5b ist eine Variation der Anordnung gem. Fig. 7a, dahingehend, daß Zonen erhöhter Dotierung 7a, 7b auf dem Boden der n-Schicht 4 und an den Seitenwänden der Gräben eingebracht sind, während die Tiefen der Zonen 8 und 10 geringer sind als die Dicke der n-Schicht 4. Zum Erreichen der maximalen Sperrspannung werden die Dotierungen der Schichten 4 und 7a so gewählt, daß beim vollständigen Verarmen dieser Schichten 4 und 7a die kritische Feldstärke nicht überschritten wird.

Die Anordnung gem. Fig. 5c ist eine weitere Variation der Anordnung in Fig. 5a, wobei die Tiefen der Zonen 8 und 10 geringer sind als die Dicke der n-Schicht 4. Die Dotierung der n-Schicht 4 ist so gewählt, daß beim vollständigen Verarmen der n-Schicht 4 die kritische Feldstärke nicht überschritten wird. Der erreichbare Wert der Durchbruchsspannungen ist annähernd so hoch wie bei der Ausführungsform nach Fig. 1.

Das Substrat 1a besteht vorzugsweise aus Silizium. Die elektrisch leitfähige Schicht 11 besteht insbesondere aus halbleitendem, sauerstoffreichem Silizium (SIPOS) oder siliziumreichem Siliziumnitrid. Die Vorteile der leitfähigen Schicht 11 ergeben sich auch, wenn die Schicht 11 aus polykristallinem Silizium oder Metall-Siliziden besteht. Die dielektrische Schicht 2, 12 besteht vorzugsweise aus Siliziumdioxid, Si₃N₄, Al₂O₃ oder AlN.

## Patentansprüche

1. Halbleiterstruktur, bestehend aus einem Substrat (1a), einer auf dem Substrat angeordneten dielektrischen Schicht (2, 12) und einer auf der dielektrischen Schicht angeordneten, niedrig dotierten Halbleiterschicht (1b), welche Halbleiterschicht wenigstens ein laterales, eine hohe Durchbruchsspannung aufweisendes Halbleiterbauelement mit stark dotierten Halbleiterzonen (8, 10) die in die niedrig dotierte Halbleiterschicht von der Oberfläche der Halbleiterschicht her eingebracht sind, aufweist,
**dadurch gekennzeichnet,**
daß innerhalb der an das Substrat (1a) angrenzenden dielektrischen Schicht (2, 12) wenigstens unter demjenigen Bereich des lateralen Halbleiterbauelements, der im Sperrzustand des Halbleiterbauelements gegenüber dem Substrat ein hohes Potential aufweist, eine elektrisch leitfähige Schicht (11) eingelagert ist, die sich im Sperrzustand auf einem dem Substrat gegenüber erhöhten Potential befindet.

2. Halbleiterstruktur nach Anspruch 1,
**dadurch gekennzeichnet,**
daß in die niedrig dotierte Halbleiterschicht (1b) von der Oberfläche her eine erste Halbleiterzone (8), die einen ersten Leitfähigkeitstyp mit einer höheren Fremdatomkonzentration als die niedrig dotierte Halbleiterschicht (1b) aufweist und sich bis zur dielektrischen Schicht (12) erstreckt, und eine zweite Halbleiterzone (9), die den ersten Leitfähigkeitstyp und eine niedrigere Fremdatomkonzentration als die erste Halbleiterzone aufweist und diese umgibt, und eine dritte Halbleiterzone (10) eingelassen ist, die einen zweiten Leitfähigkeitstyp mit einer Fremdatomkonzentration, die höher ist als diejenige der niedrig dotierten Halbleiterschicht (1b) ist, aufweist und die außerhalb der zweiten Halbleiterzone liegt und sich bis zur dielektrischen Schicht erstreckt.

3. Halbleiterstruktur nach Anspruch 2,
**dadurch gekennzeichnet,**
daß die erste und dritte Halbleiterzone über Ausnehmungen (12a, 12b, 12c) in der dielektrischen Schicht (12) mit der leitfähigen Schicht (11) verbunden sind.

4. Halbleiterstruktur nach Anspruch 2,
**dadurch gekennzeichnet,**
daß die niedrig dotierte Halbleiterschicht (1b) zwischen der ersten und dritten Halbleiterzone über Ausnehmungen (15, 16) in der dielektrischen Schicht (12) mit der leitfähigen Schicht (11) verbunden ist.

5. Halbleiterstruktur nach Anspruch 2,
**dadurch gekennzeichnet,**
daß die leitfähige Schicht (11) von der niedrig dotierten Halbleiterzone (1b) und der ersten und dritten Halbleiterzone elektrisch isoliert und extern kontaktiert ist.

6. Halbleiterstruktur nach Anspruch 2,
**dadurch gekennzeichnet,**
daß die leitfähige Schicht (11) innerhalb der dielektrischen Schicht elektrisch isoliert angeordnet ist.

7. Halbleiterstruktur nach Anspruch 1,
**dadurch gekennzeichnet,**
daß in die niedrig dotierte Halbleiterschicht (1b) von der Oberfläche her eine erste Halbleiterzone (8), die einen ersten Leitfähigkeitstyp mit einer höheren Fremdatomkonzentration als die niedrig dotierte Halbleiterschicht (1b) aufweist und sich nicht bis zur dielektrischen Schicht (12) erstreckt, und eine zweite Halbleiterzone (9), die bei gleichem Leitfähigkeitstyp eine niedrigere Fremdatomkonzentration als die erste Halbleiterzone aufweist und diese umgibt, und eine dritte Halbleiterzone (10) von einem zweiten Leitfähigkeitstyp eingelassen sind, deren Fremdatomkonzentration höher ist als diejenige der niedrig dotierten Halbleiterschicht (1b), und daß vierte Halbleiterzonen (7a, 7b) das laterale Halbleiterbauelement umschließend angeordnet sind.

8. Halbleiterstruktur nach Anspruch 7,
**dadurch gekennzeichnet**,
daß die vierten Halbleiterzonen jeweils durch Ausnehmungen (12d, 12e) in der dielektrischen Schicht (2) mit der leitfähigen Schicht (11) verbunden sind und daß die Dotierung der niedrig dotierte Halbleiterschicht (1b) so eingestellt ist, daß beim vollständigen Verarmen der niedrig dotierten Halbleiterschicht (1b) bis zur vierten Halbleiterzone die Durchbruchsfeldstärke des Halbleitermaterials nicht überschritten wird.

9. Halbleiterstruktur nach Anspruch 8,
**dadurch gekennzeichnet,**
daß die vierte Halbleiterzone am Boden der Driftzone mit der leitfähigen Schicht (11) verbunden ist.

10. Halbleiterstruktur nach Anspruch 8 oder 9,
**dadurch gekennzeichnet,**
daß die vierte Halbleiterzone nahe an der seitlichen Isolierschicht mit der leitfähigen Schicht verbunden ist.

11. Halbleiterstruktur nach Anspruch 7,
**dadurch gekennzeichnet,**
daß die leitfähige Schicht (11) von der vierten Halbleiterzone isoliert ist.

12. Halbleiterstruktur nach Anspruch 11,
**dadurch gekennzeichnet,**
daß die leitfähige Schicht (11) extern kontaktiert ist.

13. Halbleiterstruktur nach Anspruch 1,
**dadurch gekennzeichnet,**
daß in die niedrig dotierte Halbleiterschicht (1b) von der Oberfläche her eine erste Halbleiterzone (8), die einen ersten Leitfähigkeitstyp mit einer höheren Fremdatomkonzentration als die niedrig dotierte Halbleiterschicht (1b) aufweist und sich nicht bis zur dielektrischen Schicht (12) erstreckt und eine zweite Halbleiterzone (9), die bei gleichem Leitfähigkeitstyp eine niedrigere Fremdatomkonzentration als die erste Halbleiterzone aufweist und diese umgibt, und eine dritte Halblei-terzone (10) von einem zweiten Leitfähigkeitstyp, deren Fremdatomkonzentration höher als diejenige der niedrig dotierten Halbleiterschicht (1b) ist, eingelassen sind.

14. Halbleiterstruktur nach Anspruch 13,
**dadurch gekennzeichnet,**
daß die leitfähige Schicht (11) über Ausnehmungen (12a, 12b, 12c) unterhalb der ersten und der dritten Halbleiterzonen mit der niedrig dotierten Halbleiterschicht (1b) verbunden ist.

15. Halbleiterstruktur nach Anspruch 13,
**dadurch gekennzeichnet,**
daß die leitfähige Schicht (11) über Ausnehmungen (15, 16) in der dielektrischen Schicht (2) zwischen der ersten und dritten Halbleiterzone mit der niedrig dotierten Halbleiterschicht (1b) verbunden ist.

16. Halbleiterstruktur nach Anspruch 13,
**dadurch gekennzeichnet,**
daß die leitfähige Schicht (11) von der niedrig dotierten Halbleiterschicht (1b) elektrisch isoliert ist.

17. Halbleiterstruktur nach Ansprüchen 13, 14 oder 15,
**dadurch gekennzeichnet,**
daß die leitfähige Schicht (11) extern kontaktiert ist.

18. Halbleiterstruktur nach Ansprüchen 2, 7 oder 13,
**dadurch gekennzeichnet,**
daß die leitfähige Schicht (11) aus einzelnen voneinander isolierten Teilbereichen (11a, 11b, 11c ... 11n) besteht.

19. Halbleiterstruktur nach Anspruch 1 oder 2,
**dadurch gekennzeichnet,**
daß das Substrat (1a) aus Silizium besteht.

20. Halbleiterstruktur nach Ansprüchen 2, 7 oder 13,
**dadurch gekennzeichnet,**
daß die elektrisch leitfähige Schicht (11) aus halbleitendem, sauerstoffreichem Silizium (SIPOS) oder siliziumreichem Siliziumnitrid besteht.

21. Halbleiterstruktur nach Ansprüchen 2, 7 oder 13,
**dadurch gekennzeichnet,**
daß die elektrisch leitfähige Schicht (11) aus polykristallinem Silizium oder Metall-Siliziden besteht.

22. Halbleiterstruktur nach einem oder mehreren der vorhergehenden Ansprüche,
**dadurch gekennzeichnet,**
daß die dielektrische Schicht (2, 12) aus Siliziumdioxid besteht.

23. Halbleiterstruktur nach einem oder mehreren der Ansprüche 2 bis 21,
**dadurch gekennzeichnet,**
daß die dielektrische Schicht (2, 12) aus Si₃N₄, Al₂O₃ oder AlN besteht.

## Claims

1. Semiconductor structure consisting of a substrate (1a), a dielectric layer (2, 12) arranged on the substrate and a low-doped semiconductor layer (1b) arranged on the dielectric layer, which semiconductor layer has at least one lateral semiconductor element, which exhibits a high breakdown voltage, with strongly doped semiconductor zones (8, 10), which are formed In the low-doped semiconductor layer going in from the surface of the semiconductor layer, characterised thereby that an electrically conductive layer (11), which in the blocking state is disposed at a potential increased relative to the substrate (1a), is inserted within the dielectric layer (2, 12), which adjoins the substrate (1a), at least under that region of the lateral semiconductor element which in the blocking state of the semiconductor element has a high potential relative to the substrate.

2. Semiconductor structure according to claim 1, characterised thereby that embedded in the low-doped semiconductor layer (1b) going in from the surface are a first semiconductor zone (8), which has a first conductivity type with a higher foreign atom concentration than the low-doped semiconductor layer (1b) and extends up to the dielectric layer (12), and a second semiconductor zone (9), which has the first conductivity type and a lower foreign atom concentration than the first semiconductor zone and surrounds this, and a third semiconductor zone (10), which has a second conductivity type with a foreign atom concentration higher than that of the low-doped semiconductor layer (1b) and which lies outside the second semiconductor zone and extends up to the dielectric layer.

3. Semiconductor structure according to claim 2, characterised thereby that the first and third semiconductor zones are connected with the conductive layer (11) by way of recesses (12a, 12b, 12c) in the dielectric layer (12).

4. Semiconductor structure according to claim 2, characterised thereby that the lowdoped semiconductor layer (1b) is connected with the conductive layer (11) between the first and third semiconductor zones by way of recesses (15, 16) in the dielectric layer (12).

5. Semiconductor structure according to claim 2, characterised thereby that the conductive layer (11) is electrically insulated from the low-doped semiconductor zone (1b) and the first and third semiconductor zones and can be made contact with externally.

6. Semiconductor structure according to claim 2, characterised thereby that the conductive layer (11) is arranged electrically insulated within the dielectric layer.

7. Semiconductor structure according to claim 1, characterised thereby that embedded in the low-doped semiconductor layer (1b) going in from the surface are a first semiconductor zone (8), which has a first conductivity type with a higher foreign atom concentration than the low-doped semiconductor layer (1b) and does not extend up to the dielectric layer (12), and a second semiconductor zone (9), which with the same conductivity type has a lower foreign atom concentration than the first semiconductor zone and surrounds this, and a third semiconductor zone (10) of a second conductivity type, the foreign atom concentration of which is higher than that of the low-doped semiconductor layer (1b), and that fourth semiconductor zones (7a, 7b) are arranged to surround the lateral semiconductor element.

8. Semiconductor structure according to claim 7, characterised thereby that the fourth semiconductor zones are connected with the conductive layer (11) by respective recesses (12d, 12e) in the dielectric layer (2) and that the doping of the low-doped semiconductor layer (1b) is so set that on complete weakening of the low-doped semiconductor layer (1b) up to the fourth semiconductor zone the breakdown field strength of the semiconductor material is not fallen below.

9. Semiconductor structure according to claim 8, characterised thereby that the fourth semiconductor zone is connected at the base of the drift zone with the conductive layer (11).

10. Semiconductor structure according to claim 8 or 9, characterised thereby that the fourth semiconductor zone is connected near the lateral insulating layer with the conductive layer.

11. Semiconductor structure according to claim 7, characterised thereby that the conductive layer (11) is insulated from the fourth semiconductor zone.

12. Semiconductor structure according to claim 11, characterised thereby that the conductive layer (11) can be made contact with externally.

13. Semiconductor structure according to claim 1, characterised thereby that embedded in the low-doped semiconductor layer (1b) going in from the surface are a first semiconductor zone (8), which has a first conductivity type with a higher foreign atom concentration than the low-doped semiconductor layer (1b) and does not extend up to the dielectric layer (12), and a second semiconductor zone (9), which with the same conductivity type has a lower foreign atom concentration than the first semiconductor zone and surrounds this, and a third semiconductor zone (10) of a second conductivity type, the foreign atom concentration of which is higher than that of the low-doped semiconductor layer (1b).

14. Semiconductor structure according to claim 13, characterised thereby that the conductive layer (11) is connected with the low-doped semiconductor layer (1b) by way of recesses (12a, 12b, 12c) below the first and the third semiconductor zones.

15. Semiconductor structure according to claim 13, characterised thereby that the conductive layer (11) is connected with the low-doped semiconductor layer (1b) by way of recesses (15, 16) in the dielectric layer (2) between the first and third semiconductor zone.

16. Semiconductor structure according to claim 13, characterised thereby that the conductive layer (11) is electrically insulated from the low-doped semiconductor zone (1b).

17. Semiconductor structure according to claim 13, 14 or 15, characterised thereby that the conductive layer can be made contact with externally.

18. Semiconductor structure according to claim 2, 7 or 13, characterised thereby that the conductive layer (11) consists of individual part regions (11a, 11b, 11c ...11n) insulated from one another.

19. Semiconductor structure according to claim 1 or 2, characterised thereby that the substrate (1a) consists of silicon.

20. Semiconductor structure according to claim 2, 7 or 13, characterised thereby that the conductive layer (11) consists of semiconductive, oxygen-enriched silicon (SIPOS) or silicon-enriched silicon-nitride.

21. Semiconductor structure according to claim 2, 7 or 13, characterised thereby that the conductive layer (11) consists of polycrystalline silicon or metal silicides.

22. Semiconductor structure according to one or more of the preceding claims, characterised thereby that the dielectric layer (2, 12) consists of silicon dioxide.

23. Semiconductor structure according to one or more of claims 2 to 21, characterised thereby that the dielectric layer (2, 12) consists of Si₃N₄, Al₂0₃ or AlN.

## Revendications

1. Structure semiconductrice se composant d'un substrat (la), d'une couche diélectrique (2, 12) disposée sur le substrat et d'une couche semiconductrice (1b) faiblement dopée, disposée sur la couche diélectrique, laquelle couche semiconductrice comporte au moins un composant semiconducteur présentant une tension de claquage élevée avec des zones semiconductrices (8, 10) fortement dopées qui sont disposées dans la couche semiconductrice faible dopée depuis la surface de la couche semiconductrice, caractérisée en ce qu'à l'intérieur de la couche diélectrique (2, 12) adjacente au substrat (la), au moins sous cette région du composant semiconducteur latéral, qui présente, dans l'état de blocage du composant semiconducteur, un potentiel vis-à-vis du substrat, est introduite une couche électriquement conductrice (11), qui, dans l'état bloqué, se trouve à un potentiel accru vis-à-vis du substrat.

2. Structure semiconductrice selon la revendication 1, caractérisée en ce que, dans la couche semiconductrice (1b) faiblement dopée, s'étend, depuis la surface, une première zone semiconductrice (8), qui présente un premier type de conductivité avec une concentration en impuretés plus élevée que la couche semiconductrice faiblement dopée (1) et s'étend jusqu'à la couche diélectrique (12), et une seconde zone semiconductrice (9), qui présente le premier type de conductivité et une concentration en impuretés plus faible que la première zone semiconductrice et entoure celle-ci, et une troisième couche semiconductrice (10) est introduite, qui présente un second type de conductivité avec une concentration en impuretés plus élevée que celle de la couche semiconductrice faiblement dopée (1b), et qui se trouve à l'extérieur de la seconde zone semiconductrice et s'étend jusqu'à la couche diélectrique.

3. Structure semiconductrice selon la revendication 2, caractérisée en ce que la première et la troisième zones semiconductrices sont réunies par l'intermédiaire d'évidements (12a, 12b, 12c) dans la couche diélectrique (12) à la couche conductrice (11).

4. Structure semiconductrice selon la revendication 2, caractérisée en ce que la couche semiconductrice faiblement dopée (1b) entre la première et la troisième zones semiconductrices est reliée par l'intermédiaire d'évidements (15, 16) dans la couche diélectrique (12) à la couche conductrice (11).

5. Structure semiconductrice selon la revendication 2, caractérisée en ce que la couche conductrice (11) est isolée de la zone semiconductrice faiblement dopée (1b) et de la première et de la troisième zones semiconductrices et est contactée extérieurement.

6. Structure semiconductrice selon la revendication 2, caractérisée en ce que la couche conductrice (11) est disposée électriquement isolée à l'intérieur de la couche diélectrique.

7. Structure semiconductrice selon la revendication 1, caractérisée en ce que, dans la couche semiconductrice faiblement dopée (1b), présente, depuis la surface, une première zone semiconductrice (8), qui présente un premier type de conductivité avec une concentration en impuretés plus élevée que la couche semiconductrice faiblement dopée (1) et ne s'étend pas jusqu'à la couche diélectrique (12), et présente une seconde zone semiconductrice (8), qui, pour un même type de conductivité, présente une concentration en impuretés plus faible que la première zone semiconductrice et entoure celle-ci, et une troisième zone semiconductrice (10) d'un second type de conductivité sont introduites, dont la concentration en impuretés est plus élevée que celle de la couche semiconductrice faiblement dopée (1b), et en ce que des quatrièmes zones semiconductrices (7a, 7b) sont disposées entourant le composant semiconducteur latéral.

8. Structure semiconductrice selon la revendication 7, caractérisée en ce que les quatrièmes zones semiconductrices sont réunies respectivement grâce à des évidements (12d, 12e) dans la couche diélectrique (2) à la couche conductrice (11) et en ce que le dopage de la couche semiconductrice faiblement dopée (1b) est fixé de sorte que, dans le cas de l'épuisement total de la couche semiconductrice faiblement dopée (1b) jusqu'à la quatrième zone semiconductrice, l'intensité du champ de claquage du matériau semiconducteur n'est pas dépassée.

9. Structure semiconductrice selon la revendication 8, caractérisée en ce que la quatrième zone semiconductrice est reliée au fond de la zone de dérive à la couche conductrice (11).

10. Structure semiconductrice selon la revendication 8 ou 9, caractérisée en ce que la quatrième zone semiconductrice est reliée près de la couche isolante latérale à la couche conductrice.

11. Structure semiconductrice selon la revendication 7, caractérisée en ce que la couche conductrice (11) est isolée de la quatrième zone semiconductrice (12).

12. Structure semiconductrice selon la revendication 11, caractérisée en ce que la couche conductrice (11) est contactée extérieurement.

13. Structure semiconductrice selon la revendication 1, caractérisée en ce que, dans la couche semiconductrice faiblement dopée (1b), sont introduites, depuis la surface, une première zone semiconductrice (8), qui présente un premier type de conductivité avec une concentration en impuretés plus élevée que la couche semiconductrice faiblement dopée (1b) et ne s'étend pas jusqu'à la couche diélectrique (12) et une seconde zone semiconductrice (9), qui, pour un même type de conductivité, présente une concentration en impuretés plus faible que la première zone semiconductrice et entoure celle-ci, et une troisième zone semiconductrice (10) d'un second type de conductivité, dont la concentration en impuretés est plus élevée que celle de la couche semiconductrice faiblement dopée (1b).

14. Structure semiconductrice selon la revendication 13, caractérisée en ce que la couche conductrice (11) est reliée, par l'intermédiaire d'évidements (12a, 12b, 12c) au-dessous des première et troisième zones semiconductrices, à la couche semiconductrice faiblement dopée (1b).

15. Structure semiconductrice selon la revendication 13, caractérisée en ce que la couche conductrice (11) est reliée par l'intermédiaire d'évidements (15, 16) dans la couche diélectrique (2) entre la première et la troisième zones semiconductrices à la couche semiconductrice faiblement dopée (1b).

16. Structure semiconductrice selon la revendication 13, caractérisée en ce que la couche conductrice (11) est isolée électriquement de la couche semiconductrice faiblement dopée (1b).

17. Structure semiconductrice selon les revendications 13, 14 ou 15, caractérisée en ce que la couche conductrice (11) est contactée extérieurement.

18. Structure semiconductrice selon les revendications 2, 7 ou 13, caractérisée en ce que la couche conductrice (11) se compose de différentes régions partielles isolées les unes des autres (11a, 11b, 11c... 11n).

19. Structure semiconductrice selon la revendication 1 ou 2, caractérisée en ce que le substrat (la) est en silicium.

20. Structure semiconductrice selon les revendications 2, 7 ou 13, caractérisée en ce que la couche électriquement conductrice (11) est en silicium riche en oxygène, semiconducteur (SIPOS) ou en nitrure de silicium riche en silicium.

21. Structure semiconductrice selon les revendications 2, 7 ou 13, caractérisée en ce que la couche électriquement conductrice (11) est en silicium polycristallin ou en siliciures métalliques.

22. Structure semiconductrice selon l'une ou plusieurs des revendications précédentes, caractérisée en ce que la couche diélectrique (2, 12) est en dioxyde de silicium.

23. Structure semiconductrice selon l'une ou plusieurs des revendications 2 à 21, caractérisée en ce que la couche diélectrique (2, 12) est en Si₃N₄, Al₂O₃ ou AlN.
